# EUROPÄISCHE PATENTSCHRIFT

(11) **EP 1 629 330 B1**
(45) Veröffentlichungstag und Bekanntmachung des Hinweises auf die Patenterteilung: **17.03.2010**
(21) Anmeldenummer: 04739529.8
(22) Anmeldetag: 02.06.2004
(51) Int. Cl.: H03K 17/96

(54) **KAPAZITIVER BERÜHRUNGSSCHALTER**
CAPACITIVE CONTACT SWITCH
DETECTEUR DE PROXIMITE CAPACITIF

(30) Priorität: 03.06.2003 DE 10326684
(43) Veröffentlichungstag der Anmeldung: 01.03.2006
(73) Patentinhaber: E.G.O. Control Systems GmbH, 72336 Balingen (DE)
(72) Erfinder: STREIFLER, Rolf, 72367 Weilen (DE)
(74) Vertreter: Patentanwälte Ruff, Wilhelm, Beier, Dauster & Partner
(86) Internationale Anmeldenummer: PCT/EP2004/005949
(87) Internationale Veröffentlichungsnummer: WO 2004/107062

(56) Entgegenhaltungen:
- EP-A- 1 207 439
- US-A- 5 453 960
- US-A1- 2002 145 594
- US-A1- 2002 149 572

## Beschreibung

### Anwendungsgebiet und Stand der Technik

Die Erfindung betrifft eine Sensorvorrichtung gemäß dem Oberbegriff des Anspruchs 1 zur Erzeugung eines Schaltsignals oder Auslösesignals bei Annäherung und/oder Berührung eines Sensorelements der Sensorvorrichtung durch Annäherung eines Fingers oder dergleichen.

Eine derartige Sensorvorrichtung ist bekannt aus der DE 201 197 00.6. Hier ist hinter einer Abdeckung in Form einer Glasblende oder Kunststoffblende eine elektrisch leitfähige Schicht vorgesehen, beispielsweise als Bedruckung. Sie ist elektrisch kontaktiert zu einer entsprechenden Ansteuerung.

Die US-PS 5,453,960 zeigt, wie ein Sensorelement bzw. eine Elektrode 5 fest und unlösbar auf die Unterseite eines Uhrenglases 3 aufgebracht ist und mit einem Schaltkreis 4 verbunden ist. Das Sensorelement kann beispielsweise eine bestimmte Form haben bzw. ein Symbol darstellen.

Die EP 1207439 A1 zeigt eine weitere Möglichkeit, ein Sensorelement bzw. eine durchsichtige Elektrode an der Unterseite eines Uhrenglases zu befestigen. Diese Elektroden können beispielsweise aus durchsichtigem ITO (Indium Zink Oxid) bestehen, welches als Beschichtung unlösbar auf das Uhrenglas aufgebracht ist.

### Aufgabe und Lösung

Der Erfindung liegt die Aufgabe zugrunde, eine eingangs genannte Sensorvorrichtung zu schaffen, mit der eine Weiterbildung des Standes der Technik möglich ist.

Gelöst wird diese Aufgabe durch eine Sensorvorrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß weist eine eingangs genannte Sensorvorrichtung ein kapazitives Sensorelement auf. Dieses ist flächig ausgedehnt bzw. definiert eine Fläche. Es weist eine Bedruckung oder Beschichtung auf, welche leitfähiges Material enthalten. So bildet das Sensorelement eine elektrisch leitfähige Fläche. Das Sensorelement ist an einer von einem Benutzer abgewandten Rückseite einer flächigen Blende angeordnet. Diese Blende kann beispielsweise an einem elektrischen Gerät vorgesehen sein, wobei sie transluzent oder durchsichtig ist. Das Sensorelement ist leitend mit einer Steuerung verbunden zur Ansteuerung und Auswertung des Sensorelements. Erfindungsgemäß ist hier vorgesehen, dass die Bedruckung oder Beschichtung bzw. das Sensorelement an sich durchsichtig oder lichtdurchlässig sind. Dies ermöglicht es, eine Beleuchtung oder Leuchtanzeige unterhalb eines Sensorelements anzuordnen, ohne dass entsprechende Ausschnitte oder Lichtdurchlässe in dem Sensorelement vorgesehen sein müssen. Dadurch ist es vor allem auch möglich, die Funktion eines Berührungsschalters mit einem Sensorelement direkt einer entsprechenden Anzeige oder Beleuchtung zuzuordnen. So ist eine besonders gute Kennzeichnung für einen Benutzer möglich.

Die durchsichtige Bedruckung oder Beschichtung kann sich vorteilhaft über die gesamte Fläche des Sensorelements erstrecken bzw. bildet vorteilhaft das gesamte Sensorelement. So ist ein einheitlicher Aufbau möglich. Alternativ kann lediglich eine Teilfläche des Sensorelements eine durchsichtige Bedruckung oder Beschichtung aufweisen. Diese kann in Symbolform vorliegen, beispielsweise um mittels Durchleuchtung ein Symbol darzustellen.

Bei der Erfindung ist das Sensorelement auf eine durchsichtige bzw. lichtdurchlässige Folie aufgedruckt oder als Schicht aufgebracht. Diese Folie, welche somit sozusagen das Sensorelement trägt, wird an der Rückseite der Blende angebracht. Somit sind Sensorelement und Blende getrennte Bauteile. So kann beispielsweise die Herstellung der Blende einfacher erfolgen und es ist ein flexiblerer Zusammenbau verschiedener Bauteile möglich.

Bei der vorgenannten Ausbildung der Erfindung kann die Folie auch einstückig nicht nur das Sensorelement, sondern auch die Kontaktierung an die Steuerung bilden. Dazu kann die leitfähige Bedruckung oder Beschichtung verwendet werden. Mit dieser kann die Folie von der Blendenrückseite in einem Stück bis zu der Steuerung verlaufen, welche mit gewissem Abstand hinter der Blende angeordnet sein kann. Ist die Steuerung auf einer Leiterplatte angeordnet, so kann die Folie bis zu dieser Leiterplatte reichen. Dort kann sie beispielsweise auf einem entsprechend ausgebildeten Kontaktfeld elektrisch kontaktierend befestigt sein. Hier eignen sich beispielsweise elektrisch leitfähige Kleber, ebenso eine vorzugsweise federnde Klemmung.

Hinter dem Sensorelement kann an der Blendenrückseite ein Beleuchtungsmittel vorgesehen sein. Dieses kann einen Lichtleiter aufweisen mit einer zugeordneten Beleuchtung. Ein Lichtleiter weist den Vorteil auf, dass die Beleuchtung, welche beispielsweise eine LED, Glimmlampe oder dergleichen sein kann, an einer anderen bzw. entfernt liegenden Stelle vorgesehen sein kann. Des weiteren können so, beispielsweise durch flache Lichtleiter, welche eine Lichtumlenkung aufweisen können, sehr niedrige Bauhöhen erreicht werden. Diese können ansonsten nicht unbedingt leicht erreicht werden.

Hier ist es vorteilhaft, wenn Lichtleiter und Beleuchtung, also beispielsweise LED, getrennte oder zumindest trennbare Bauteile sind. So ist eine größere Flexibilität möglich. Des weiteren ist es auch vorstellbar, mit einer einzigen LED über mehrere Lichtleiter mehrere Sensorelemente zu beleuchten.

Wenn ein Beleuchtungsmittel als Baueinheit hinter einem Sensorelement angeordnet ist und das Sensorelement in Folienform vorliegt, kann das Sensorelement um das Beleuchtungsmittel herumreichen, vorzugsweise einhüllend oder umgebend. Dadurch kann erreicht werden, dass sich Beleuchtungsmittel und Sensorelement gegenseitig bzw. gemeinsam fixieren. Des weiteren kann das Beleuchtungsmittel gegen denjenigen Bereich des Sensorelements bzw. der Folie gedrückt sein, der an der Blendenrückseite anliegt. So kann eine Platzierung und Fixierung des Sensorelements erfolgen. Dabei kann das Sensorelement bzw. die Folie in diesem Bereich an sich lose sein und wird erst durch das Beleuchtungsmittel fixiert.

In weiterer Ausgestaltung der Erfindung können die Beleuchtungsmittel eine Anzeige aufweisen. Dies kann eine Sieben-Segment-Anzeige sein, beispielsweise ein LED-Display oder ein vakuum-fluoreszierendes Display (VF-Display) sein. Diese Anzeigen leuchten von selber, benötigen also keine eigene Beleuchtung und sind durch die durchsichtige Blende sowie durch das durchsichtige Sensorelement hindurch gut erkennbar.

Ein weiterer Vorteil eines durchsichtigen kapazitiven Sensorelements ist der, dass so die Sensorelementfunktion direkt beleuchtet werden kann. Insbesondere gilt dies bei der Verwendung von beleuchteten Symbolen, auf welche ein Benutzer den Finger legt. Somit ist eine möglichst störungsfreie Betätigung erreichbar.

Die elektrische Leitfähigkeit der Bedruckung oder Beschichtung kann durch elektrisch leitfähige Bestandteile erreicht werden. Diese können einerseits beispielsweise Graphit oder dergleichen sein. Andererseits können es metallische Bestandteile sein. Ein mögliches Anwendungsbeispiel ist Indium-Zinn-Oxid (ITO). Des weiteren ist es von Vorteil, wenn die Beschichtung eine geringe Dicke aufweist. So ist zum einen der Aufwand geringer und ein Sensorelement in Folienform weist bessere Flexibilität auf. Des weiteren ist eine geringe Dicke von Vorteil für die Lichtdurchlässigkeit der Bedruckung oder Beschichtung. Beispielhafte Dicken sind im Bereich von 5 bis 100µm, insbesondere 10 bis 20µm.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: einen Schnitt durch eine erfindungsgemäße Sensorvorrichtung unter einer durchsichtigen Abdeckung, wobei eine leitfähig beschichtete Folie ein Sensorelement bildet, hinter dem eine Leuchtanzeige angeordnet ist,
- Fig. 2: eine Abwandlung der Anordnung aus Fig. 1, wobei die Folie um die Leuchtanzeige herum geführt ist zu einer Kontaktierung, und
- Fig. 3: einen Schnitt durch eine Folie mit leitfähiger Beschichtung.

### Detaillierte Beschreibung der Ausführungsbeispiele

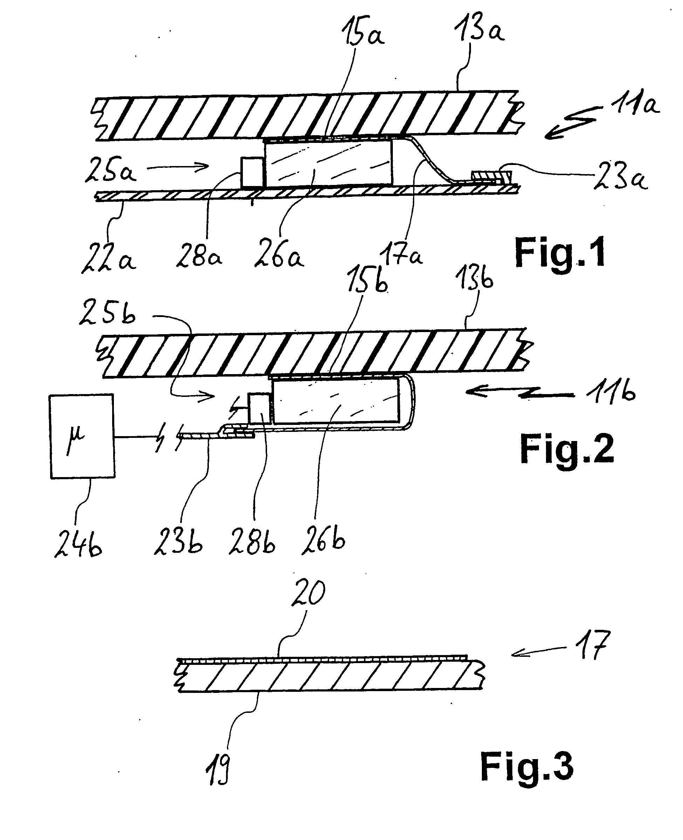

In Fig. 1 ist eine erste Möglichkeit einer Sensorvorrichtung 11a dargestellt. Unter einer Abdeckung 13a, welche durchsichtig sein kann und beispielsweise eine Bedienblende eines Elektrogeräts sein kann, ist die Sensorvorrichtung 11a angeordnet. Die Sensorvorrichtung 11a besteht aus einem kapazitiven Sensorelement 15a, welches eine Fläche bildet und an der Unterseite der Abdeckung 13a anliegt.

In Fig. 3 ist ein Flachmaterial 17 dargestellt, aus welchem das Sensorelement 15a bestehen kann. Das Flachmaterial 17 besteht aus einer Trägerfolie 19. Diese kann eine geringe Dicke aufweisen, beispielsweise einige zehntel Millimeter oder sogar weniger, und durchsichtig sein. Auf einer Seite der Trägerfolie 19, in Fig. 3 die Oberseite, ist eine Beschichtung 20. Diese Beschichtung 20 kann beispielsweise sogenanntes ITO sein. Dieses weist den Vorteil auf, dass es einerseits eine gute elektrische Leitfähigkeit aufweist, auch mit geringen Schichtdicken. Des weiteren ist es mit diesen geringen Schichtdicken transparent bzw. lichtdurchlässig und durchsichtig. Die Dicke der Beschichtung 20 kann bei einer ITO-Beschichtung im Bereich von 50µm oder weniger liegen.

Es ist von Vorteil, wenn das Flachmaterial 17 bzw. Trägerfolie 19 samt Beschichtung biegbar oder flexibel sind. So kann das Flachmaterial 17 gleichzeitig als elektrische Kontaktierung bzw. flexible elektrische Beschichtung verwendet werden. So können beispielsweise Formen gestaltet werden, wie sie in Fig. 1 und 2 dargestellt sind.

Bei der Sensorvorrichtung 11a gemäß Fig. 1 läuft das Flachmaterial 17, welches im Bereich der Rückseite der Abdeckung 13a das Sensorelement 15a bildet, in einem S-förmigen Bogen weg von der Abdeckung. Es wird in einer Kontaktklemme 23a mechanisch gehalten und elektrisch kontaktiert. Die Kontaktklemme 23a kann dabei so ausgebildet sein, dass sie den elektrischen Kontakt zwischen Flachmaterial 17 bzw. elektrisch leitfähiger Beschichtung 20 und einem entsprechenden Anschluss auf der Leiterplatte 22a, auf der die Kontaktklemme 23a sitzt, herstellt. Die Kontaktklemme 23a kann dazu federnd sein. Weitere Möglichkeiten sind elektrisch leitfähige Verklebungen. Von der Kontaktklemme 23a verläuft eine Verbindung zu einer Steuerung 24a, auf die hier nicht näher eingegangen zu werden braucht, da sie an sich auf für kapazitive Sensorelemente übliche Art und Weise ausgeführt sein kann.

An der Rückseite des Sensorelements 15a liegt eine Leuchtanzeige 25a an. Diese wird gebildet von einem Lichtleiterelement 26 und einer seitlich angeordneten LED 28a. Lichtleiterelement 26a und LED 28a sind vorteilhaft auf derselben Leiterplatte 22a angeordnet und insbesondere elektrisch kontaktiert wie die Kontaktklemme 23a. Somit kann die Leiterplatte 22a zusammen mit den darauf angeordneten Bauteilen eine Baueinheit bilden. Das Sensorelement 15a kann dabei entweder lose zwischen Lichtleiterelement 26a und Abdeckung 13 geklemmt werden. Des weiteren kann es auch mit dem Lichtleiterelement 26a fest verbunden sein, beispielsweise geklebt. Anstelle einer Leuchtanzeige 25a kann auch eine Sieben-Segment-Anzeige oder dergleichen vorgesehen sein.

Bei der Abwandlung einer Sensorvorrichtung 11 b gemäß Fig. 2 ist auch ein Sensorelement 15b vorgesehen, welches aus dem Flachmaterial 17b gebildet ist. In dem Bereich, in dem das Flachmaterial 17b das Sensorelement 15b bildet, wird dieses von einer Leuchtanzeige 25b gegen die Unterseite der Abdeckung 13b gedrückt. Die Leuchtanzeige 25b ist dabei im wesentlichen wie diejenige ausgebildet, welche in Fig. 1 dargestellt ist.

Mit dem anderen freien Ende ragt das Flachmaterial 17b, nachdem es einmal um die Leuchtanzeige 25b geführt ist, in eine Kontaktklemme 23b. Diese Kontaktklemme 23b ist ähnlich einer Aufnahmegabel oder dergleichen ausgebildet und kann aus Metall bestehen. Das Ende des Flachmaterials 17b kann darin eingeklemmt und elektrisch kontaktiert werden. Insofern ist es hier ohne Bedeutung, welche Seite des Flachmaterials 17b eine leitfähige Beschichtung aufweist. Die Kontaktklemme 23b führt zu der Steuerung 24b.

In weiterer Ausgestaltung der Erfindung ist es auch möglich, auf die Rückseite der Abdeckung 13 ein kapazitives Sensorelement mit einer leitfähigen Fläche aufzubringen, beispielsweise aufzudrucken. Durch eine Anordnung eines leitfähigen Flachmaterials 17 ähnlich der Fig. 1 oder 2 kann die elektrische Kontaktierung leicht vorgenommen werden. Die lichtdurchlässigen Eigenschaften des Flachmaterials, insbesondere auch der elektrisch leitfähigen Beschichtung 20, ermöglichen es, Beleuchtungen oder Leuchtanzeigen dahinter anzuordnen. Die elektrisch leitfähigen Flächen von Sensorelementen, insbesondere kapazitiven Sensorelementen, brauchen in diesem Fall nicht mehr, wie es bisher der Fall war, entsprechende Ausschnitte aufzuweisen, um eine Lichtdurchstrahlung zu ermöglichen.

### Funktion

Von der Funktion her wird bei einer Leuchtanzeige 25a gemäß Fig. 1 Licht von der LED 28a seitlich in das Lichtleiterelement 26a eingestrahlt. Dieses reflektiert das Licht nach vorne durch das Flachmaterial 17 bzw. das Sensorelement 15a und die Abdeckung 13. So können entweder hinterleuchtete Sensorelemente geschaffen werden, welche durch zusätzliche Bedruckung oder Masken oder dergleichen auf dem Lichtleiterelement oder an dem Sensorelement ein bestimmtes Aussehen haben können. Dies kann beispielsweise die Darstellung eines Symbols oder dergleichen sein.

Durch die Darstellungen, insbesondere diejenigen der Sensorvorrichtung 11 a und 11 b gemäß den Fig. 1 und 2, wird verdeutlicht, inwiefern mit einer erfindungsgemäßen Sensorvorrichtung bzw. der Ausbildung des leitfähig beschichteten Flachmaterials 17 neue und vorteilhafte Möglichkeiten geschaffen werden können, elektrische Verbindungen allgemein zu schaffen sowie insbesondere kapazitive Sensorelemente zu bilden. Durch die flexiblen Eigenschaften des Flachmaterials 17 ist eine vielfältige Führung sowie Kontaktierung möglich. Es kann somit eine einstückige Ausführung von Sensorelement bzw. Sensorelementfläche und elektrischer Kontaktierung oder Zuleitung geschaffen werden.

## Patentansprüche

1. Sensorvorrichtung (11) zur Erzeugung eines Schaltsignals bei Annäherung und/oder Berührung eines Sensorelements (15) durch Annäherung eines Fingers oder dergleichen, mit:
- einem kapazitiven Sensorelement (15), das eine Fläche definiert und eine Bedruckung oder Beschichtung mit leitfähigem Material aufweist,
- einer flächigen Blende (13) aus transluzentem oder durchsichtigem Material, wobei das Sensorelement auf (15) einer von einem Benutzer abgewandten Rückseite der Blende angeordnet ist und
- einer mit dem Sensorelement (15) verbundenen Steuerung (24),
wobei das Sensorelement (15) eine leitende Kontaktierung zu der Steuerung (24) aufweist, wobei die Bedruckung oder Beschichtung (20) des Sensorelements (15) durchsichtig ist,
**dadurch gekennzeichnet, dass** die Bedruckung oder Beschichtung (20) auf eine durchsichtige Folie (19) aufgebracht ist, welche an der Rückseite der Blende (20) angeordnet ist.

2. Sensorvorrichtung nach Anspruch 1, **dadurch gekennzeichnet, dass** sich die Bedruckung oder Beschichtung (20) über die wesentliche, insbesondere die gesamte, Fläche des Sensorelements (15) erstreckt.

3. Sensorvorrichtung nach Anspruch 1 oder 2, **dadurch gekennzeichnet, dass** eine Teilfläche des Sensorelements (15) eine Bedruckung aufweist, vorzugsweise eine Bedruckung in Symbolform.

4. Sensorvorrichtung nach einem der Ansprüche 1 bis 3, **dadurch gekennzeichnet, dass** die Folie (19) flächig an der Rückseite der Blende anliegt.

5. Sensorvorrichtung nach Anspruch 4, **dadurch gekennzeichnet, dass** die Folie (19) einstückig das Sensorelement (15) und eine Kontaktierung (23) an die Steuerung (24) bildet, wobei sie von der Rückseite der Blende (13) einstückig an die Steuerung (24) reicht, wobei vorzugsweise die Steuerung auf einer Leiterplatte (22) angeordnet ist und die Folie (19) bis zu der Leiterplatte reicht.

6. Sensorvorrichtung nach Anspruch 5, **gekennzeichnet durch** eine elektrische Kontaktierung der Folie (19) an die Steuerung (24) über eine Befestigung an einem Kontaktfeld der Steuerung, vorzugsweise mittels leitfähigen Klebers.

7. Sensorvorrichtung nach einem der vorhergehenden Ansprüche, **dadurch gekennzeichnet, dass** hinter dem Sensorelement (15) an der Rückseite der Blende (13) ein Beleuchtungsmittel (25) angeordnet ist, vorzugsweise ein Lichtleiter (26), insbesondere mit einer LED (28) zur Beleuchtung.

8. Sensorvorrichtung nach Anspruch 7, **dadurch gekennzeichnet, dass** ein Sensorelement (15) nach Art einer Folie (17) zumindest teilweise um das Beleuchtungsmittel (25) herumreicht.

9. Sensorvorrichtung nach Anspruch 7 oder 8, **dadurch gekennzeichnet, dass** das Beleuchtungsmittel (25) gegen den Bereich der Folie (17) an der Rückseite der Blende (13) gedrückt ist, wobei vorzugsweise dieser Folienbereich an sich lose ist.

10. Sensorvorrichtung nach einem der Ansprüche 7 bis 9, **dadurch gekennzeichnet, dass** die Beleuchtungsmittel (25) eine Anzeige aufweisen, vorzugsweise ein LED-Display oder ein VF-Display.

## Claims

1. A sensor device (11) for generating a switching signal when a sensor element (15) is approached and/or touched by the approach of a finger or the like, having:
- a capacitive sensor element (15), which defines a surface and comprises a print or coating with conductive material,
- a flat panel (13) of translucent or transparent material, the sensor element (15) being arranged on the back, remote from a user, of the panel and
- a control (24) connected to the sensor element (15),
the sensor element (15) comprising a conductive contacting means for contacting the control (24), the print or coating (20) on the sensor element (15) being transparent,
**characterised in that** the print or coating (20) is applied to a transparent film (19), which is arranged on the back of the panel (13).

2. A sensor device according to claim 1, **characterised in that** the print or coating (20) extends over the substantial, in particular the entire, surface of the sensor element (15).

3. A sensor device according to claim 1 or claim 2, **characterised in that** a sub-surface of the sensor element (15) comprises a print, preferably a print in the form of symbols.

4. A sensor device according to any one of claims 1 to 3, **characterised in that** the film (19) lies flat against the back of the panel.

5. A sensor device according to claim 4, **characterised in that** the film (19) forms in one piece the sensor element (15) and a contacting means (23) for contacting the control (24), said film extending in one piece from the back of the panel (13) to the control (24), the control preferably being arranged on a printed circuit board (22) and the film (19) extending as far as the printed circuit board.

6. A sensor device according to claim 5, **characterised by** electrical contacting of the film (19) with the control (24) by fastening to a contact field of the control, preferably by means of conductive adhesive.

7. A sensor device according to any one of the preceding claims, **characterised in that** an illumination means (25), preferably a light guide (26), in particular with an LED (28) for illumination purposes, is arranged behind the sensor element (15) on the back of the panel (13).

8. A sensor device according to claim 7, **characterised in that** a sensor element (15) extends at least partially around the illumination means (25) in the manner of a film (17).

9. A sensor device according to claim 7 or claim 8, **characterised in that** the illumination means (25) is pressed against the region of the film (17) on the back of the panel (13), this film region preferably not being in itself attached to anything.

10. A sensor device according to any one of claims 7 to 9, **characterised in that** the illumination means (25) comprise a display, preferably an LED display or a VF display.

## Revendications

1. Dispositif de détection (11) produisant un signal de commutation à l'approche et/ou au contact d'un élément capteur (15) lors de l'approche d'un doigt ou d'une action similaire, avec :
- un élément capteur capacitif (15) définissant une surface et présentant une impression ou un revêtement avec du matériau conducteur,
- un panneau plan (13) en matériau translucide ou transparent, l'élément capteur (15) étant disposé sur une face arrière du panneau située à l'opposé de l'utilisateur, et
- une commande (24) reliée à l'élément capteur (15),
sachant que l'élément capteur (15) présente un contact conducteur avec la commande (24) et que l'impression ou le revêtement (20) de l'élément capteur (15) est transparent,
**caractérisé en ce que** l'impression ou le revêtement (20) est appliqué sur un film transparent (19) qui est disposé sur la face arrière du panneau (13).

2. Dispositif de détection selon la revendication 1, **caractérisé en ce que** l'impression ou le revêtement (20) s'étend sur l'essentiel de la surface de l'élément capteur (15), en particulier sur toute cette surface.

3. Dispositif de détection selon la revendication 1 ou 2, **caractérisé en ce qu'**une partie de la surface de l'élément capteur (15) présente une impression, de préférence une impression en forme de symbole.

4. Dispositif de détection selon l'une des revendications 1 à 3, **caractérisé en ce que** le film (19) est couché à plat sur la face arrière du panneau.

5. Dispositif de détection selon la revendication 4, **caractérisé en ce que** le film (19) forme en une seule partie l'élément capteur (15) et un contact (23) avec la commande (24), sachant qu'il s'étend en une seule partie de la face arrière du panneau (13) à la commande (24), que la commande est disposée de préférence sur une carte de circuit imprimé (22) et que le film (19) s'étend jusqu'à la carte de circuit imprimé.

6. Dispositif de détection selon la revendication 5, **caractérisé en ce que** le film (19) est en contact électrique avec la commande (24) par une fixation sur un champ de contact de la commande, de préférence au moyen d'une colle conductrice.

7. Dispositif de détection selon l'une des revendications précédentes, **caractérisé en ce qu'**un moyen d'éclairage (25) est disposé derrière l'élément capteur (15) sur la face arrière du panneau (13), de préférence un conducteur de lumière (26), en particulier avec une DEL (28) pour l'éclairage.

8. Dispositif de détection selon la revendication 7, **caractérisé en ce qu'**un élément capteur (15) s'étend au moins en partie autour du moyen d'éclairage (25) tel un film (17).

9. Dispositif de détection selon la revendication 7 ou 8, **caractérisé en ce que** le moyen d'éclairage (25) est appuyé contre la zone du film (17) sur la face arrière du panneau (13), cette zone du film étant de préférence lâche en soi.

10. Dispositif de détection selon l'une des revendications 7 à 9, **caractérisé en ce que** les moyens d'éclairage (25) présentent un dispositif d'affichage, de préférence un afficheur à diodes électroluminescentes ou fluorescent.
